# EUROPEAN PATENT APPLICATION

(11) **EP 2 224 475 A1**
(43) Date of publication of application: **01.09.2010**
(21) Application number: 08861860.8
(22) Date of filing: 12.12.2008
(51) Int. Cl.: H01L 21/677, C23C 16/44, H01L 21/205, H01L 21/31

(54) **PROCESSING METHOD AND SEMICONDUCTOR DEVICE MANUFACTURING METHOD**

(30) Priority: 18.12.2007 JP 2007326168
(71) Applicant: Sumitomo Electric Industries, Ltd., Chuo-ku Osaka-shi Osaka 541-0041 (JP)
(72) Inventor: SHIBATA, Kaoru, Itami-shi Hyogo 664-0016 (JP); NAKANISHI, Fumitake, Itami-shi Hyogo 664-0016 (JP)
(74) Representative: Grünecker, Kinkeldey, Stockmair & Schwanhäusser Anwaltssozietät
(86) International application number: PCT/JP2008/072649
(87) International publication number: WO 2009/078354

(57) **Abstract**

There are obtained a processing method that allows adherence of foreign particles to an object to be processed in a load lock chamber to be suppressed, and a fabrication method of a semiconductor device using the processing method. The processing method includes the step of receiving a substrate that is the object to be processed at a load lock chamber (substrate load lock chamber) to load the substrate into a processing chamber where processing is to be applied to the substrate (step (S21) in Fig. 3), and reducing internal pressure from a substrate load lock chamber 3 (step (S23) in Fig. 3). In the step of reducing internal pressure (S23), pressure is released at a relatively low decompression rate, and then at a relatively high decompression rate.

## Description

### TECHNICAL FIELD

The present invention relates to a processing method and a fabrication method of a semiconductor device. More particularly, the present invention relates to a processing method of suppressing adherence of foreign particles to an object to be processed loaded into a processing chamber via a load lock chamber, and a fabrication method of a semiconductor device.

### BACKGROUND ART

In a processing apparatus that applies various processing on a workpiece target such as a semiconductor substrate (for example, film deposition, etching, and the like on the semiconductor substrate), contaminants (particles and the like) adhering to the surface of the target of processing during a relevant process have become an issue in the aspect of processing quality. Various processing methods have been conventionally proposed to prevent such adherence of a foreign particle (for example, refer to Japanese Patent Laying-Open No. 2005-116823 (hereinafter, referred to as Patent Document 1) and Japanese Patent Laying-Open No. 2005-079250 (hereinafter, referred to as Patent Document 2)).

In order to prevent adherence of foreign particles to a target of processing (an object to be processed) when the target is transferred by a transfer arm, Patent Document 1 is directed to preventing adherence of foreign particles to a target of processing by charging the foreign particle by means of an ion source in the region where the transfer arm is installed, and supplying a DC voltage of a polarity identical to that of the charged foreign particle to the target of processing. Patent Document 2 discloses the usage of a pod (vessel) to hold a target of processing inside for the purpose of transferring the target of processing to a processing apparatus, and introducing nitrogen gas towards the target of processing from an opening in the pod used for the entrance of the target of processing.
Patent Document 1: Japanese Patent Laying-Open No. 2005-116823
Patent Document 2: Japanese Patent Laying-Open No. 2005-079250

### DISCLOSURE OF THE INVENTION

### PROBLEMS TO BE SOLVED BY THE INVENTION

The conventional processing methods set forth above are to prevent adherence of foreign particles during the transfer of the target of processing to the load lock chamber in the processing apparatus, and were not effective for adherence of a foreign particle to a target of processing subsequent to transfer of the target to the load lock chamber.

In view of the foregoing, an object of the present invention is to provide a processing method that allows adherence of a foreign particle to a target of processing in a load lock chamber to be suppressed, and a fabrication method of a semiconductor device employing the processing method.

### MEANS FOR SOLVING THE PROBLEMS

The inventors found that, in a processing apparatus that carries out load-in and load-out of a target of processing via a load lock chamber, the state of adherence of foreign particles onto the surface of a target of processing during processing of the target is improved by a processing method carried out at the load lock chamber. Specifically, the processing method according to the present invention includes the steps of receiving a target of processing (an object to be processed) at a load lock chamber to load the target of processing into a processing chamber where processing on the target is to be carried out, and reducing the internal pressure in the load lock chamber. The step of reducing the internal pressure includes the step of releasing pressure at a relatively low decompression rate, and then releasing pressure at a relatively high decompression rate.

Accordingly, the number of foreign particles adhering to the surface of a target of processing can be reduced as compared to the conventional case where pressure is reduced at a relatively high decompression rate as the initial pressure reducing step in a pressure reducing mode carried out at a load lock chamber.

A fabrication method of a semiconductor device according to the present invention employs the processing method set forth above. The target of processing is a semiconductor substrate. The fabrication method includes the steps of carrying out the processing method set forth above, loading the target of processing from the load lock chamber into the processing chamber, and carrying out processing on the target of processing in the processing chamber. Accordingly, a predetermined process (for example, film deposition, etching, and the like) can be applied on a semiconductor substrate identified as a target of processing having the amount of adhering particles reduced. Therefore, the processing quality can be improved at the surface of semiconductor substrate. Thus, generation of a defect caused by adherence of foreign particles can be suppressed, lowering the possibility of the fabrication yield of semiconductor devices being decreased in view of such a defect.

### EFFECTS OF THE INVENTION

According to the present invention, adherence of foreign particles to a target of processing in a load lock chamber for loading the target of processing into the processing chamber can be suppressed effectively.

### BRIEF DESCRIPTION OF THE DRAWINGS

Fig. 1 is a schematic diagram representing a processing apparatus that carries out a processing method of the present invention.
Fig. 2 is a flowchart representing a processing method at the processing apparatus of Fig. 1.
Fig. 3 is a flowchart to describe contents of a load-in preparation step to the processing chamber of Fig. 2.
Fig. 4 is a graph representing a decompression pattern in the substrate load lock chamber employed in experiments.

### DESCRIPTION OF THE REFERENCE CHARACTERS

1 processing apparatus; 2 processing chamber; 3 substrate load lock chamber; 4, 5 gate; 6 gas supply unit; 7, 8, 11, 12 pipe; 9 valve; 10 vacuum pump; 13 substrate; 15-18 arrows of flow of the substrate.

### BEST MODES FOR CARRYING OUT THE INVENTION

Embodiments of the present invention will be described hereinafter with reference to the drawings. In the drawings, the same or corresponding elements have the same reference number allotted, and description thereof will not be repeated.

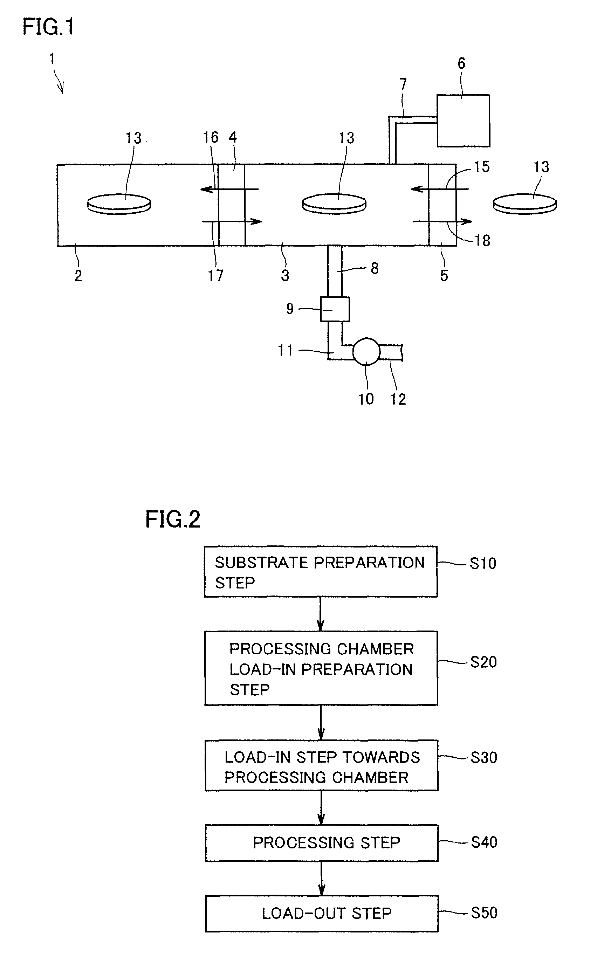

A processing apparatus and processing method of the present invention will be described with reference to Figs. 1-3.

Referring to Fig. 1, a processing apparatus 1 of the present invention includes a processing chamber 2 where a predetermined processing such as deposition and etching is carried out on a substrate 13 that is a target of processing (an object to be processed), a substrate load lock chamber 3 where substrate 13 to be supplied to processing chamber 2 is transferred between processing chamber 2 and a region outside processing apparatus l, a gas supply unit 6 for supplying gas to substrate load lock chamber 3, and a valve 9 and a vacuum pump 10 constituting an exhaust system for output of gas from substrate load lock chamber 3. Processing chamber 2 is partitioned off substrate load lock chamber 3 by a gate 4 that can be opened. In addition, substrate load lock chamber 3 is partitioned off the region outside apparatus 1 by a gate 5 that can be opened. Substrate load lock chamber 3 is employed to receive a substrate 13 from outside the apparatus without causing a significant change in the internal state (ambient gas and ambient pressure) of processing chamber 2.

Gas supply unit 6 is connected to substrate load lock chamber 3 via a pipe 7. Gas supply unit 6 can supply gas such as nitrogen into substrate load lock chamber 3 via pipe 7. In addition, a valve 9 is connected to substrate load lock chamber 3 via a pipe 8. A pump 10 is connected to valve 9 via a pipe 11. Pump 10 has its output side connected to another pipe 12. By these pipes 8, 11 and 12, valve 9, and vacuum pump 10 constituting an exhaust system, ambient gas can be output from substrate load lock chamber 3.

Although not shown, a member to supply reaction gas to carry out a predetermined process, an exhaust system to set the interior of processing chamber 2 at a predetermined pressure level, a heater to heat the interior of processing chamber 2 to a predetermined processing temperature, a member such as an electrode to produce plasma required for a process and the like are installed at processing chamber 2. An arbitrary process on substrate 13 can be carried out at processing chamber 2. For example, dry etching, film deposition based on CVD and the like, an exposure process to transfer a predetermined pattern onto a resist film formed in advance on the surface of substrate 13, ion implantation towards substrate 13, or the like may be carried out at processing chamber 2.

Processing chamber 2 and substrate load lock chamber 3 are unified by opening gate 4. The configuration of the apparatus employed for transferring substrate 13 between processing chamber 2 and substrate load lock chamber 3 may be based on a conventional well-known arbitrary configuration. For example, substrate 13 may be carried between processing chamber 2 and substrate load lock chamber 3 by a substrate holder that can move therebetween. In addition, substrate load lock chamber 3 and the region outside processing apparatus 1 are unified by opening gate 5. The configuration of the apparatus employed for loading in substrate 13 into substrate load lock chamber 3 from outside the processing apparatus may be based on a conventional well-known arbitrary configuration. For example, the method of moving a stage on which substrate 13 is mounted into substrate load lock chamber 3 may be employed.

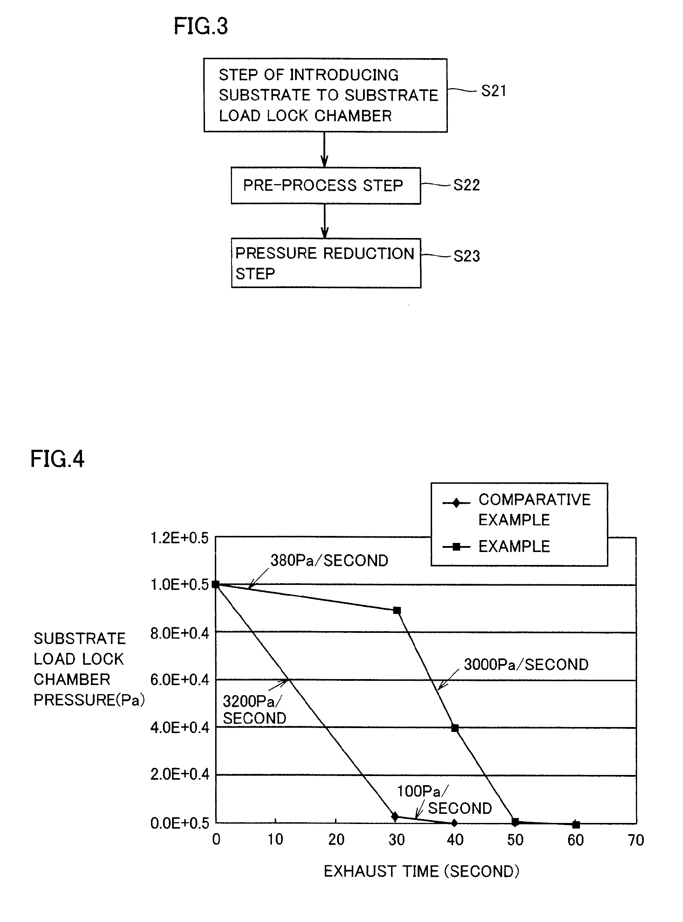

A processing method of a substrate using the processing apparatus of Fig. 1 will be described hereinafter with reference to Figs. 2 and 3. As shown in Fig. 2, first a substrate preparation step (S10) is carried out. At this step (S10), substrate 13 that is the target of processing is prepared, as shown in Fig. 1.

Then, a load-in preparation step (S20) towards the processing chamber is carried out. This step (S20) includes the steps shown in Fig. 3. In this load-in preparation step (S20), the step of introducing a substrate into the substrate load lock chamber is first carried out (S21), as shown in Fig. 3. Specifically, referring to Fig. 1, substrate 13 that is the target of processing is introduced into substrate load lock chamber 3 from outside processing apparatus 1, as shown by arrow 15. At this stage, gate 5 is opened, and substrate 13 is introduced into substrate load lock chamber 3, as indicated by arrow 15 in Fig. 1, via the aperture formed by opening gate 5. At this stage, gate 4 is closed. Therefore, the internal state of processing chamber 2 (the type of ambient gas, ambient pressure, and the like) is maintained constant even when substrate 13 is loaded into substrate load lock chamber 3.

Then, a pre-processing step (S22) shown in Fig. 3 is carried out as the load-in preparation step (S20). Specifically, following closure of gate 5, purge gas consisting of nitrogen gas (N₂ gas) is supplied from gas supply unit 6 into substrate load lock chamber 3 via pipe 7. Alternatively, argon gas, helium gas, or the like may be employed as purge gas instead of nitrogen gas. As a result, the interior of substrate load lock chamber 3 attains a pressure level slightly higher than that outside processing apparatus 1 (positive pressure state). Before releasing the pressure at the pressure reduction step that will be described afterwards, the interior of substrate load lock chamber 3 is set at the positive pressure state. The internal pressure of substrate load lock chamber 3 under this positive pressure state can be set to the range of 101325Pa to 152000Pa, more preferably to the range of 121600Pa to 141900Pa. The reason why the internal pressure under the positive pressure state is defined at the aforementioned range is that the effect of suppressing particle adherence will not be improved greatly even if the substrate load lock chamber is maintained at a pressure level higher than the aforementioned upper limit and that no significant effect in preventing particle adherence can be seen when the pressure level is lower than the aforementioned lower limit.

Then, a pressure reduction step (S23) is carried out. In this step (S23), exhaust gas is output from substrate load lock chamber 3 via valve 9 and pump 10. At this stage, the output speed of the exhaust gas (the ratio of change in the pressure level in substrate load lock chamber 3) is modified in discrete steps by operating valve 9. Specifically, the degree of opening at valve 9 is set small from the start of pressure release to an elapse of a predetermined time, so that the ratio of reduction of the pressure level in substrate load lock chamber 3 (decompression rate) can be set relatively low. The decompression rate at this first stage can be set to the range of 200Pa/second to 700Pa/second, for example, more preferably to the range of 200Pa/second to 400Pa/second. This range of decompression rate is selected by the following reasons. If pressure is released at a rate exceeding the upper limit of the aforementioned range of decompression rate, a significant effect of suppressing particle adherence cannot be achieved. If the pressure is released at a rate lower than the lower limit of the aforementioned decompression rate, pressure release will be too time-consuming, and the effect of reducing particle adherence will not be greatly improved even if the decompression rate is set lower than the lower limit.

The time for carrying out pressure release of the first stage (predetermined time) can be set to the range of 30 seconds to 120 seconds, more preferably to the range of 30 seconds to 60 seconds. The reason why the period of time for pressure release of the first stage is set to the aforementioned range is that there is no effect in suppressing particle adherence even if pressure is released for a period of time longer than the upper limit of the aforementioned operation time, and that adherence of particles will be increased if pressure is reduced over a time shorter than the lower limit of the aforementioned operation time.

Further, the pressure release at the first stage may be carried out such that the pressure in substrate load lock chamber 3 is lowered to the range of 80% to 95% of the pressure at the start of pressure release, more preferably to the range of 90% to 95% of the pressure at the start of pressure release.

At the point of time when a predetermined time elapses, the degree of opening of valve 9 is increased to set the ratio of pressure reduction in substrate load lock chamber 3 (decompression rate) relatively high. The decompression rate at this second stage can be set to the range of 2000Pa/second to 3200Pa/second, for example, preferably to the range of 3000Pa/second to 3200Pa/second. The speed of pressure release at this latter stage is preferably set equal to the speed of pressure release conventionally carried out in substrate load lock chamber 3 or lower than the conventional decompression speed. By the pressure reduction step (S23) set forth above, the pressure in substrate load lock chamber 3 is reduced down to a predetermined pressure level.

Then, a load-in step (S30) of Fig. 2 towards the processing chamber is carried out. Specifically, gate 4 (refer to Fig. 1) is set open. Then, substrate 13 is introduced from substrate load lock chamber 3 into processing chamber 2, as indicated by arrow 16 in Fig. 1, via the aperture established by opening gate 4.

Further, the processing step (S40) is carried out, as shown in Fig. 2. Specifically, following closure of gate 4, a predetermined process is carried out on substrate 13 in processing chamber 2. At this processing step (S40), an arbitrary process such as the aforementioned etching and film deposition may be carried out.

Then, a load-out step (S50) is carried out. Specifically, substrate 13 subjected to a predetermined process in processing chamber 2 is moved as shown by arrow 17 into substrate load lock chamber 3 via the aperture established by opening gate 4. Then, gate 4 is closed, and predetermined gas is supplied into substrate load lock chamber 3 from gas supply unit 6 via pipe 7. As a result, the pressure in substrate load lock chamber 3 becomes substantially equal to the pressure outside substrate 1. Then, substrate 13 is taken out from processing apparatus 1, as indicated by arrow 18, through the aperture established by opening gate 5. Thus, the processing on substrate 13 is carried out in processing apparatus 1. In the case where substrate 13 is a semiconductor substrate such as a GaN substrate, a semiconductor device can be produced by carrying out film deposition, etching, and the like onto the surface of substrate 13 employing processing apparatus 1 set forth above.

The inventors found out that the amount of foreign particles such as contaminants adhering to the surface of substrate 13 in substrate load lock chamber 3 can be reduced by virtue of a pressure reduction step (S23) in which the interior of substrate load lock chamber 3 is released in pressure at a decompression rate lower than that of a conventional case in the state where substrate 13 to be processed is held in substrate load lock chamber 3, as shown in Fig. 3 in the processing method set forth above. The inventors also found that the step of increasing the pressure inside by supplying purge gas or the like beforehand (preprocess step (S22)) in the preparation step (S20) is effective in reducing the amount of adherence of foreign particles. As a result, the probability of a defect occurring in substrate 13 as a result of the processing at processing chamber 2 on substrate 13 caused by the presence of particles can be reduced.

The characteristic configuration of the present invention will be cited hereinafter, although a portion may overlap with those set forth above. The processing method of the present invention includes the step of receiving substrate 13 that is the target of processing (the object to be processed) at the load lock chamber (substrate load lock chamber 3) in order to introduce substrate 13 to processing chamber 2 where processing is applied to substrate 13 (step (S21) in Fig. 3), and the step of reducing the internal pressure in substrate load lock chamber 3 (step (S23) in Fig. 3). In the step of reducing the internal pressure (S23), pressure is released at a relatively low decompression rate, and then at a relatively high decompression rate, as shown by the pressure release pattern in the example of Fig. 4.

Accordingly, the number of contaminants (particles) adhering to the surface of substrate 13 can be reduced as compared to the conventional case where pressure is released at a relatively high decompression rate at the initial stage of pressure release during the pressure release mode of substrate load lock chamber 3.

The processing method set forth above may further include the step of supplying purge gas into substrate load lock chamber 3 (step (S22) in Fig. 3), prior to the internal pressure reduction step (S23). In this case, adherence of foreign particles to substrate 13 in substrate load lock chamber 3 can be further reduced.

In the processing method, the relatively low decompression rate is greater than or equal to 200Pa/second and less than or equal to 700Pa/second, and the relatively high decompression rate is greater than or equal to 2000Pa/second and less than or equal to 3200Pa/second. By selecting the range set forth above for the decompression rate in this case, adherence of foreign particles to substrate 13 can be suppressed reliably.

A fabrication method of a semiconductor device according to the present invention employs the processing method set forth above. Substrate 13 is a semiconductor substrate. The fabrication method includes the step of carrying out the processing method (step (S20) in Fig. 2), the step of loading substrate 13 into processing chamber 2 from substrate load lock chamber 3 (step (S30) in Fig. 2), and the step of applying processing to substrate 13 in processing chamber 2 (step S40) in Fig. 2). Accordingly, a predetermined process (for example, film deposition, etching, or the like) can be applied on a semiconductor substrate (substrate 13) having the adhering amount of foreign particles reduced. Therefore, the quality in processing at the surface of substrate 13 can be improved. Since generation of a defect caused by adherence of foreign particles on the surface of substrate 13 can be suppressed, the possibility of reduction in the fabrication yield of the semiconductor device based on substrate 13, caused by such a defect, decreases.

In the processing method or fabrication method of a semiconductor device set forth above, the target of processing (the object to be processed) may be a wide bandgap semiconductor substrate. The object to be processed may be a GaN substrate. Since a wide bandgap semiconductor substrate such as a GaN substrate is costly, the present invention is particularly advantageous since reduction in the fabrication cost is great by the improved fabrication yield.

### <Example 1>

In order to confirm the effect of the present invention, experiments set forth below were carried out.

### <Sample>

A GaN substrate having a diameter of 2 inches was prepared as the sample used in the experiment. The GaN substrate had a thickness of 0.4 mm. The surface of the GaN substrate was subjected to a cleaning process in advance. The cleaning process included solvent rinsing based on isopropyl alcohol, and alkali rinsing based on KOH.

### <Contents of Experiment>

The GaN substrate prepared as set forth above was subjected to processing through a dry etching apparatus that includes a processing chamber and a substrate load lock chamber. Specifically, a substrate was introduced into the substrate load lock chamber of the dry etching apparatus. The example of the present invention had nitrogen gas supplied into the substrate load lock chamber as the pre-processing step of Fig. 3, and the internal pressure of substrate load lock chamber 3 was set to 0.1 MPa. At this stage, the flow rate of nitrogen gas was 0.1 L/min. Then, as the pressure reduction step (S23), the substrate load lock chamber was reduced in pressure according to the pressure release pattern of the example represented by the square legend symbol in Fig. 4.

In Fig. 4, the exhaust time is plotted along the horizontal axis whereas the internal pressure in the substrate load lock chamber is plotted along the vertical axis. The exhaust time along the horizontal axis was measured in units of second whereas the pressure along the vertical axis was measured in units of Pa. The pressure release pattern indicated by the solid diamond legend symbol corresponds to that of a comparative example that will be described afterwards.

It is appreciated from Fig. 4 that pressure was released at the decompression rate of 380Pa/second from the start of pressure release up to the elapse of 30 seconds in the example of the present invention. In the time zone from the elapse of 30 seconds up to 50 seconds from the start of pressure release, the pressure in the substrate load lock chamber was reduced at the decompression rate of 3000Pa/second, Then, the internal pressure in the substrate load lock chamber was released at the decompression rate of 100Pa/second during the time zone from the elapse of 50 seconds up to 60 seconds from the start of pressure release. As a result, the internal pressure in the substrate load lock chamber was at a predetermined pressure (3Pa) level. Then, the substrate was taken out from the substrate load lock chamber, and the number of particles adhering to the surface of the substrate was measured using a particle counter.

For a GaN substrate as a comparative example in the present invention, the pressure reduction step (S23) was carried out without execution of the pre-processing step (S22), differing from the substrate of the example set forth above. Specifically, following the introduction of the GaN substrate that is the sample into the substrate load lock chamber, the pressure reduction step (S23) was carried out without the flow of nitrogen gas into the substrate load lock chamber. This pressure reduction step was carried out based on the pressure release pattern of the comparative example indicated by the diamond legend symbol in Fig. 4. Specifically, during the time zone from the start of pressure release up to 30 seconds, the pressure was reduced at the decompression rate of 3200Pa/second. Then, during the time zone from the elapse of 30 seconds up to 40 seconds from the start of pressure release, the pressure was reduced at the decompression rate of 100Pa/second. Then, the substrate was taken out from the substrate load lock chamber, and the number of particles adhering to the surface of the substrate was measured using a particle counter.

### <Results of Experiment>

The particle count at the substrate surface of the example of the present invention was 219 whereas the count of particles adhering to the surface of the substrate of the comparative example was 978. It was appreciated that the number of particles adhering to the surface of the substrate can be reduced in the case where the pre-processing step (S22) and pressure reduction step (S23) of the present invention were carried out, as compared to the comparative example corresponding to conventional steps.

### <Example 2>

### <Sample>

Four GaN substrates were prepared, similar to those of Example 1 set forth above. Two among the four GaN substrates were taken as the samples for the comparative example whereas the remaining two were taken as the sample of the present example.

### <Contents of Experiment>

For the samples of the present example, only the pressure reduction step (S23) was carried out without execution of the pre-processing step (S22) among the steps shown in Fig. 3. Specifically, a pressure release process was carried out in the substrate load lock chamber along the pressure release pattern of the example shown in Fig. 4.

In a similar manner, the pressure reduction step (S23) was carried out for the two samples of the comparative example, without execution of the pre-processing step of Fig. 3. The pressure release pattern for the comparative example shown in Fig. 4 was employed for the pressure release pattern of this pressure reduction step (S23). Following completion of the pressure reduction step (S23), the sample (substrate) was taken out from the substrate load lock chamber, and the number of particles adhering to the surface of the substrate was measured using a particle counter.

### <Result>

The particle count at the substrates of the invention of the present invention was 253 and 352, whereas the particle count for the substrates of the comparative example was 1500 and 482. It was therefore shown that the number of particles adhering to the substrate surface was reduced in the example of the present invention, as compared to the comparative example.

### <Example 3>

### <Sample>

Nine GaN substrates were prepared, similar to those of Example 1 set forth above. Six among the nine GaN substrates were taken as the samples for the present example (Examples 1-6) whereas the remaining three were taken as the samples for the comparative example (Comparative Examples 1-3).

### <Contents of Experiments>

For the GaN substrates prepared as set forth above, processing (film deposition) was carried out using a film deposition apparatus (vapor deposition apparatus) that includes a processing chamber and a substrate load lock chamber. Then, formation of an electrode, dicing, and the like were carried out to produce a schottky barrier diode (SBD) as the test element. Then, the number of particles at the surface of the GaN substrate at the stage of transfer from the substrate load lock chamber to the processing chamber of the film deposition apparatus, roughness of the film surface after film deposition, as well as the specific ON resistance and breakdown voltage of the obtained test element were measured. The details will be described hereinafter.

### <Measurement of Particle Count>

First, the GaN substrate was introduced into the substrate load lock chamber of the film deposition apparatus. For the samples of Examples 1-6, nitrogen gas was supplied into the substrate load lock chamber as the pre-processing step of Fig. 3, likewise with the sample in Example 1. The internal pressure in the substrate load lock chamber was set to 0.1 MPa. The flow rate of the supplied nitrogen gas at this stage was 0.1L/min. Then, as the pressure reduction step (S23), pressure was released from the substrate load lock chamber along the pressure release pattern of the example indicated by the diamond legend symbol in Fig. 4.

For the samples of Comparative Examples 1-3, a pressure reduction step (S23) was carried out without executing the pre-processing step (S22), differing from the GaN substrates of the example set forth above. Specifically, following introduction of the GaN substrate that is the sample into the substrate load lock chamber, the pressure reduction step (S23) was carried out without the flow of nitrogen gas into the substrate load lock chamber. In this pressure reduction step, the pressure release pattern of the comparative example indicated by the diamond legend symbol in Fig. 4 was employed.

Then, the GaN substrate was taken out from the substrate load lock chamber, and the number of particles adhering to the surface of the GaN substrate was measured using a particle counter.

### <Measurement of Surface Roughness of Deposited Film>

Using the film deposition apparatus set forth above, an epitaxial film of GaN was formed at the surface of the GaN substrate, and the surface roughness of this epitaxial film was measured. For the samples of Examples 1-6, a process similar to that for the samples of Examples 1-6 in the measurement of the particle count set forth above was carried out at the substrate load lock chamber, and then the relevant GaN substrate was loaded into the processing chamber of the film deposition apparatus. For the samples of Comparative Examples 1-3, a process similar to that for the samples of Comparative Examples 1-3 in the measurement of the particle count set forth above was carried out at the substrate load lock chamber. Then, the relevant GaN substrate was loaded into the processing chamber of the film deposition apparatus.

In the processing chamber, an epitaxial film of GaN was formed at the surface of the GaN substrate. The deposited epitaxial film had a thickness of 5 µm, and the impurity concentration (silicon (Si)) was 5 × 10¹⁵ cm ⁻³. For the deposition of an epitaxial film, MOCVD was employed, and trimethylgallium and ammonia were taken as the raw material. Further, silane (SiH₄) was employed as the doping gas for the supply of the impurity element.

Following the film deposition process, the GaN substrate with the epitaxial film was taken out from the film deposition apparatus. The surface roughness Ra of the epitaxial film was measured using a surface roughness measurement apparatus.

### < Measurement of Test Element's Specific ON Resistance and Breakdown Voltage >

An electrode was formed at the surface side of the GaN substrate with an epitaxial film obtained as set forth above (surface side of epitaxial film) and also at the back side (backside of the GaN substrate) by sputtering. At the surface side, a gold (Au) electrode having a diameter of 500 µm and a thickness of 500 nm was formed. At the back side, an electrode of a stacked structure with titanium (Ti)/aluminium (Al)/titanium (Ti)/gold (Au) located in the cited order from the GaN substrate side was formed. The thickness of respective layers in this electrode was Ti: 20 nm/Al:100 nm/Ti:20 nm /Au:300 nm. The electrode at the back side was formed so as to cover the entire back side of the GaN substrate.

Then, dicing was performed to divide the GaN substrate into test elements that are SBDs, each as an individual chip. The shape of the divided chip in plane was a rectangular, having the size of 5 mm × 5 mm. The electrode at the surface side was located substantially at the center of the chip surface.

The specific ON resistance and breakdown voltage were measured for the samples (test element) of Examples 1-6 and Comparative Examples 1-3 obtained as set forth above. The specific ON resistance was determined from the I-V property of the test element (SBD). Specifically, the specific ON resistance can be obtained by the sum of the substrate surface resistance, the drift surface resistance, and the electrode contact resistance. The substrate surface resistance was measured using the four-point probe measurement. The electrode contact resistance and drift surface resistance were measured by TLM. The specific ON resistance was obtained by adding the values of the substrate surface resistance, electrode contact resistance, and drift surface resistance. The breakdown voltage was obtained from the reverse property of the test element (SBD). Specifically, voltage was applied in the reverse direction of the test element, and the I-V property was measured. The value of the leakage current beginning to increase in response to increase of the reverse voltage was taken as the breakdown voltage (reverse voltage).

### <Result>

The results of the measurements set forth above are shown in the following Table 1.

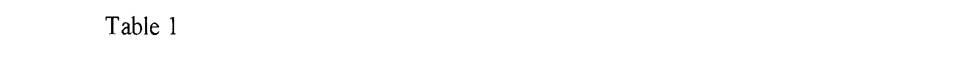

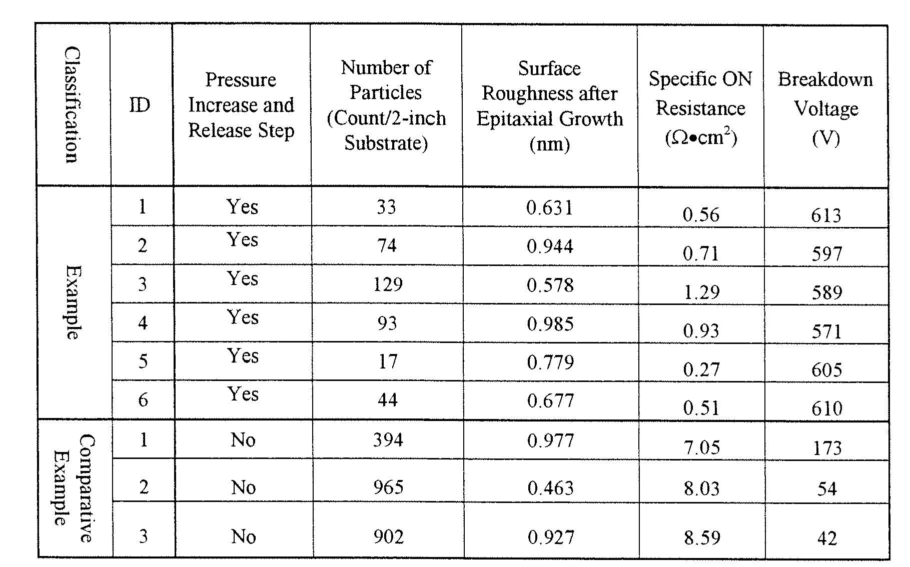

Among the items in Table 1, the ED column represents the number of each sample. The column of Pressure Increase and Release Step indicates whether the preprocess step and pressure reduction step were executed or not at the substrate load lock chamber. The column of Number of Particles represents the number of particles (contaminants) detected at the surface of a 2-inch GaN substrate. The column of Surface Roughness after Epitaxial Growth represents the surface roughness Ra (unit:nm) of the epitaxial film measured for each sample set forth above. The columns of Specific ON-resistance and Breakdown Voltage represent the specific ON resistance (unit:Ω•cm²) and breakdown voltage (unit:V) measured as set forth above.

It is appreciated from Table 1 that the particle count at the surface of the GaN substrate in the samples of Examples 1-6 is significantly reduced as compared to the samples of Comparative Examples 1-3 by virtue of the process of the present invention at the substrate load lock chamber. No significant difference was seen as to the surface roughness of the epitaxial film between Examples 1-6 and Comparative Examples 1-3.

Moreover, with regards to the device (SBD) formed using a relevant GaN substrate, there was a significant difference between Examples 1-6 and Comparative Examples 1-3 of the present invention for the specific ON resistance and breakdown voltage. Specifically, with regards to the specific ON resistance, the samples of Examples 1-6 of the present invention exhibited an extremely low value by approximately 1/several times to 1/10 times than those of the samples of Comparative Examples 1-3. With regards to the breakdown voltage, the samples of Examples 1-6 exhibited a high value of approximately 500V and above whereas the samples of Comparative Examples 1-3 exhibited a relatively lower value of approximately 40 to 170V.

Thus, the samples of examples of the present invention exhibited favorable properties, as compared to the comparative examples.

It should be understood that the embodiments and examples disclosed herein are illustrative and non-restrictive in every respect. The scope of the present invention is defined by the terms of the claims, rather than the description above, and is intended to include any modification within the scope and meaning equivalent to the terms of the claims.

### INDUSTRIAL APPLICABILITY

The present invention can be applied to a processing method of a target to be processed at a processing apparatus such as a dry etching apparatus, CVD apparatus, exposure apparatus, ion implantation apparatus, or the like that includes a processing chamber and a substrate load lock chamber.

## Claims

1. A processing method comprising the steps of:
receiving (S21) an object to be processed (13) at a load lock chamber (3) to load-in said object to be processed (13) to a processing chamber (2) where processing on said object to be processed (13) is to be carried out, and
reducing (S23) internal pressure in said load lock chamber (3),
said step of reducing internal pressure including the step of releasing pressure at a relatively low decompression rate, and then releasing pressure at a relatively high decompression rate.

2. The processing method according to claim 1, further comprising the step (S22) of supplying purge gas into said load lock chamber (3), prior to said step (S23) of reducing internal pressure.

3. The processing method according to claim 1, wherein said relatively low decompression rate is greater than or equal to 200Pa/second and less than or equal to 700Pa/second, and said relatively high decompression rate is greater than or equal to 2000/Pa/second and less than or equal to 3200Pa/second.

4. A fabrication method of a semiconductor device employing the processing method defined in claim 1,
said object to be processed including a semiconductor substrate,
said fabrication method comprising the steps of:
executing (S20) the processing method defined in claim 1,
loading (S30) said object to be processed into said processing chamber from said load lock chamber, and
applying (S40) processing to said object to be processed at said processing chamber.
